# EUROPEAN PATENT SPECIFICATION

(11) **EP 0 502 400 B1**
(45) Date of publication and mention of the grant of the patent: **17.09.1997**
(21) Application number: 92103100.1
(22) Date of filing: 24.02.1992
(51) Int. Cl.: G03F 7/038, G03F 7/039, C08G 73/10

(54) **Heat-resistant positive photoresist composition, photosensitive substrate, and process for preparing heat-resistant positive pattern**
Hitzebeständige, positiv arbeitende Photoresistzusammensetzung, lichtempfindliches Substrat, und Verfahren zur Herstellung eines hitzebeständigen positiven Musters
Composition pour photoréserve de type positif, résistante à la chaleur, substrat photosensible, et procédé pour préparer un motif positif résistant à la chaleur

(30) Priority: 05.03.1991 JP 65634/91; 04.04.1991 JP 71767/91; 15.04.1991 JP 111163/91
(43) Date of publication of application: 09.09.1992
(73) Proprietor: NITTO DENKO CORPORATION, Osaka (JP)
(72) Inventor: Omote, Toshihiko, c/o NITTO DENKO CORPORATION, Ibaraki-shi, Osaka (JP); Hayashi, Shunichi, c/o NITTO DENKO CORPORATION, Ibaraki-shi, Osaka (JP)
(74) Representative: Grünecker, Kinkeldey, Stockmair & Schwanhäusser Anwaltssozietät

(56) References cited:
- EP-A- 0 262 446
- EP-A- 0 300 326
- EP-A- 0 378 156
- EP-A- 0 436 457

## Description

The present invention relates to a heat-resistant positive photoresist composition, a photosensitive substrate obtained using the composition, and a process for preparing a heat-resistant positive pattern.

Heat-resistant photoresists employing photosensitive polyimides or precursors thereof and applications of such photoresists have been well known. For example, negative photoresists conventionally proposed include:
(1) Photoresists comprising a polyimide precursor having introduced therein a methacryloyl group through an ester bond or ionic bond (JP-A-49-11541, JP-A-50-40922, JP-A-54-145794, and JP-A-56-38038) (The term "JP-A" as used herein means an "unexamined published Japanese patent application".);
(2) Photoresists comprising a soluble polyimide containing a photopolymerizable olefin (JP-A-59-108031, JP-A-59-220730, JP-A-59-232122, JP-A-60-6729, JP-A-60-72925, and JP-A-61-57620);
(3) Photoresists comprising a self-sensitizing polyimide having a benzophenone skeleton and containing an alkyl group at the ortho position of an aromatic ring to which a nitrogen atom is bonded (JP-A-59-219330 and JP-A-59-231533); and
(4) Photoresist comprising a polybenzoxazole precursor having heat resistance almost equal to that of polyimides (Polymer Society Annual Meeting Preprints, p. 664, 1988).

On the other hand, examples of positive photoresists conventionally proposed include:
(5) Photoresist comprising a polyimide precursor having introduced therein an o-nitrobenzyl group through an ester bond (J. Macromol. Sci. Chem., A24, 10, 1407, 1987);
(6) Photoresists comprising a mixture of either a soluble hydroxyimide or a polyoxazole precursor and a naphthoquinone diazide compound (JP-B-64-60630 and U.S. Patent 4,395,482) (The term "JP-B" as used herein means an "examined Japanese patent publication".);
(7) Photoresist comprising a soluble polyimide having introduced therein naphthoquinone diazide through an ester bond (Macromolecules, 23, 1990);
(8) Photoresist employing a chemical amplification-type polyimide (U.S. Patent 5,053,314); and
(9) Photoresist comprising a mixture of a polyimide precursor and naphthoquinone diazide (JP-A-52-13315).

However, the conventional negative photoresists described above have a problem on a resolving power in its function and further have a problem in some applications that use of these negative photoresists leads to low yields of products. In addition, photoresists (2), (3), and (4) above are disadvantageous in that they are not suitable for use as a multipurpose photoresist since polymers which can be used therein are limited in structure and, hence, the properties of coating films finally obtained therefrom are limited. On the other hand, the conventional positive photoresists also have the problem of poor sensitivity and resolution as in photoresist (5) above, which are attributable to an absorption wavelength for a photosensitizer, while photoresists (6), (7), and (8) also have the same problems as in photoresists (2), (3), and (4) above because polymers or polymer precursors used therein are also limited in structure. Further, photoresist (9) above has a problem of film thickness reduction (to an initial thickness) in high temperature treatment conducted after pattern formation, so that it has not yet been put to practical use.

EP-A-378 156 discloses a positive photoresist composition comprising the polyimides of formulae (II) and (III) of the present application. The composition may further contain a photo decomposable proton generator in an amount of 1 to 50% by weight based on the amount of the polyimide.

EP-A-262 446 discloses a polyimide precursor having a structural unit represented by formula (I) of the present application.

EP-A-300 326 discloses polyimides of formula (II) of the present application. The polyimides are used for the preparation of heat resistant photoresists and can be admixed with compounds which are sensitive to actinic rays, thereby forming an acid.

In order to eliminate the above-described problems accompanying the conventional photoresist compositions, the present inventors have already developed a chemical amplification-type, positive-working photosensitive polyimide resin composition having an acyloxy group, showing excellent sensitivity and resolution (JP-A-3-763).

This photoresist composition, however, is disadvantageous in that since the hydroxyl-protecting group thereof is limited to acyloxy group, ionic impurities contaminate into the polyimide resin during synthesis of the resin, and purification of the product for removing these impurities necessitates much time and cost.

As a result of intensive studies on the above photoresist composition, it has now been found that a photoresist composition which overcomes the problems of the conventional photoresists can be obtained by blending a specific polyimide precursor or polyimide containing a protecting group capable of being eliminative under acidic or basic conditions and a compound capable of inducing an elimination reaction of the protecting group in the polyimide precursor or polyimide upon irradiation with actinic rays, or by blending the polyimide precursor and a compound which becomes basic upon irradiation with actinic rays. The present invention has been completed based on this finding.

One object of the present invention is to provide a heat-resistant positive photoresist composition showing good sensitivity and resolving power in which the polyimide precursor or polyimide which imparts photosensitivity can have any polymeric structure in the starting material thereof, which overcomes the problems of the conventional photoresists.

Another object of the present invention is to provide a photosensitive substrate employing the above heat-resistant positive photoresist composition.

Still another object of the present invention is to provide a process for preparing a heat-resistant positive pattern using the above heat-resistant positive photoresist composition.

According to one embodiment of the present invention, a first heat resistant positive photoresist composition is provided, which comprises either a polyimide precursor having a structural unit represented by formula (I): 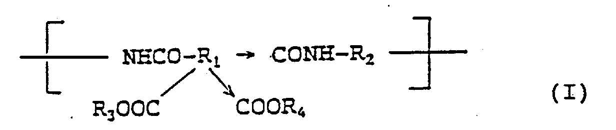 wherein
the -COOR₃ and -COOR₄ groups should always take the ortho-positions or adjacent positions with respect to the -CONH-linkages;
R₁ represents a tetravalent aromatic or aliphatic hydrocarbon residue or a diphenyl ether group, a diphenyl sulfone group, a benzophenone group or a diphenylhexafluoropropane group; R₂ represents a divalent aromatic or aliphatic hydrocarbon residue or a diphenyl ether group, a diphenyl thioether group, a benzophenone group, a diphenylhexafluoropropane group, a diphenylsulfoxide group, a diphenyl sulfone group or a pyridine group; and R₃ and R₄ each represents a hydrogen atom or an organic protecting group selected from tetrahydropyranyl, phthalimidomethyl, p-nitrobenzyl, p-methoxybenzyl, t-butyl, methoxymethyl, triphenylmethyl and tetrahydro-2-thiopyranyl which can be eliminated under acidic or basic conditions, thereby providing the corresponding carboxyl group;
or a polyimide having a structural unit represented by formula (II): 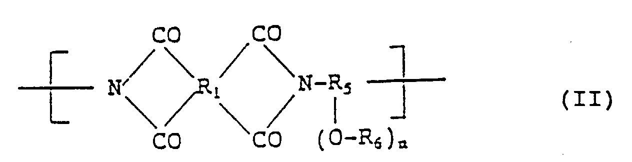 wherein R₁ is the same as defined above; R₆ represents an organic protecting group selected from tetrahydropyranyl, phthalimidomethyl, p-nitrobenzyl, p-methoxybenzyl, t-butyl, methoxymethyl, triphenylmethyl and tetrahydro-2-thiopyranyl which can be eliminated under acidic or basic conditions, thereby providing a hydroxyl group; R₅ represents an aromatic or aliphatic hydrocarbon residue having a valence of (2+n) and containing at least one hydroxyl group protected by the organic protecting group of R₆; and n is an integer of 1 to 5;
and further comprises a compound capable of inducing an elimination reaction of the organic protecting groups in the polyimide or polyimide precursor upon irradiation with actinic rays in an amount of 5 to 50 parts by weight per 100 parts by weight of the polyimide precursor or polyimide having a structural unit represented by formula (I), or (II);
and/or in case the composition comprises a polyimide precursor having a structural unit represented by formula (I), wherein at least one of R₃ and R₄ is a hydrogen atom, a compound which becomes basic upon irradiation with actinic rays is additionally present in the composition in an amount of 5 to 50 parts by weight per 100 parts by weight of the polyimide precursor.

According to another embodiment of the present invention a second heat-resistant positive photoresist composition is provided comprising a polyimide having a structural unit represented by formula (II): 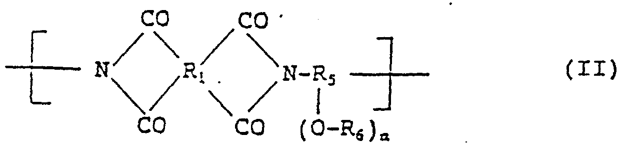 wherein
R₁ represents a tetravalent aromatic or aliphatic hydrocarbon residue or a diphenyl ether group, a diphenyl sulfone group, a benzophenone group or a diphenylhexafluoropropane group; R₆ represents an organic protecting group selected from tetrahydropyranyl, phthalimidomethyl, p-nitrobenzyl, p-methoxybenzyl, t-butyl, methoxymethyl, triphenylmethyl and tetrahydro-2-thiopyranyl which can be which can be eliminated under acidic or basic conditions, thereby providing a hydroxyl group;
R₅ represents an aromatic or aliphatic hydrocarbon residue having a valence of (2+n) and containing at least one hydroxyl group protected by the organic protecting group of R₆; and n is an integer of 1 to 5;
and further having a structural unit represented by formula (III): 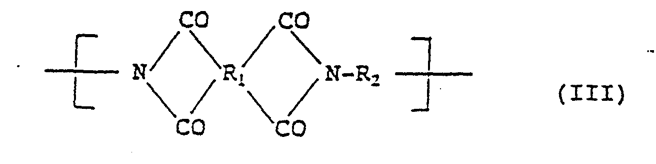 wherein R₁ is the same as the defined above and R₂ represents a divalent aromatic or aliphatic hydrocarbon residue or a diphenyl ether group, a diphenylthioether group, a benzophenone group, a diphenylhexafluoropropane group, a diphenyl sulfoxide group, a diphenyl sulfone group or a pyridine group; and/or a structural unit represented by formula (IV): 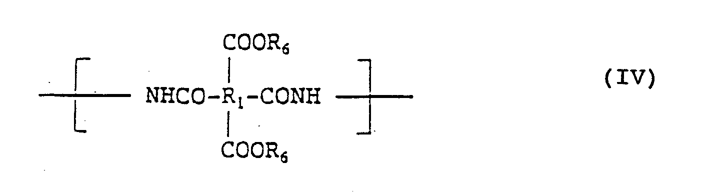 wherein R₁ and R₆ are the same as defined above;
said heat-resistant positive photoresist composition further comprising a compound capable of inducing an elimination reaction of the organic protecting groups in the polyimide upon irradiation with actinic rays.

According to still another embodiment of the present invention, a photosensitive substrate is provided which is obtained by coating a surface of a support with any one of the above described heat-resistant positive photoresist compositions.

According to a further embodiment of the present invention, a process for preparing a heat-resistant positive pattern is provided which comprises irradiating a film obtained from the heat-resistant positive photoresist composition of any of claims 1 to 6 with actinic rays through a photomask, followed by heat treatment, and then removing the irradiated areas of the resulting film by development with an alkaline developing solution, provided that the heat-resistant positive photoresist composition comprises a polyimide precursor having a structural unit represented by formula (I).

Representative examples of R₁ in the structural units represented by the formula (I) described above include tetravalent aromatic or aliphatic hydrocarbon residues having a skeleton such as benzene, naphthalene, perylene, diphenyl, diphenylpropane, butane and cyclobutane ; as well as diphenyl ether, diphenyl sulfone, diphenylhexafluoropropane and benzophenone. Preferred examples of R₁ are tetravalent residues having diphenyl or benzophenone skeleton. In all the structural units represented by the formula (I), it is not necessary for R₁ to be the same, and if required and necessary, two or more different R₁ can be included.

Representative examples of R₂ in the structural units represented by the formula (I) include divalent aromatic or aliphatic hydrocarbon residues having a skeleton such as diphenylmethane, diphenylpropane, biphenyl and benzene; as well as diphenyl ether, diphenyl thioether, benzophenone, diphenylhexafluoropropane, diphenyl sulfoxide, diphenyl sulfone and pyridine. Preferred examples of R₂ are divalent residues having diphenyl ether, diphenyl sulfone or benzene skeleton. In all the structural units represented by the formula (I), it is not necessary for R₂ to be the same, and if required and necessary, two or more different R₂ can be included.

Specific examples of the polyimide precursor containing a structural unit represented by the formula (I) include those having the following structural units:

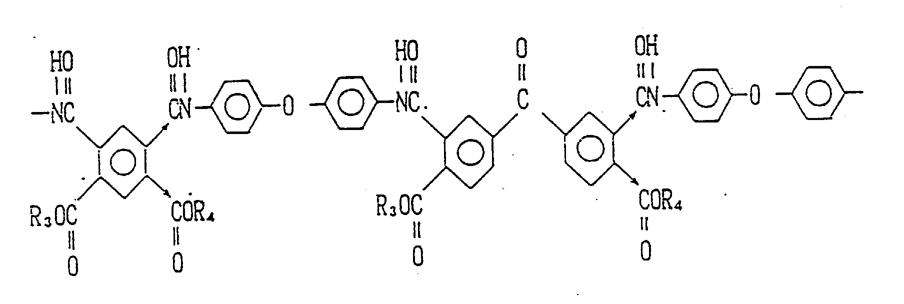

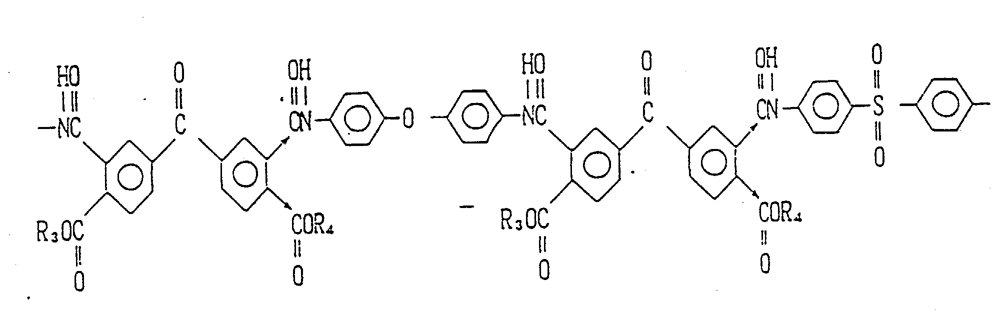

In the formula (I), R₃ and R₄ each represents hydrogen atom or an organic group which is bonded to the carboxyl group to protect it. This organic protecting group should be one which can be eliminated under acidic or basic conditions, thereby providing the corrsponding carboxyl group. Examples of the protecting group include tetrahydropyranyl group, phthalimidomethyl group, p-nitrobenzyl group, p-methoxybenzyl group, t-butyl group, methoxymethyl group, triphenylmethyl group, 2-thiolanyl group, tetrahydro-2-thiopyranyl group, and the like. Of these, tetrahydropyranyl group is preferred. In the structural unit of the formula (I), if either R₃ or R₄ is the organic protecting group as described above, the other is not necessary to be an organic protecting group and may be hydrogen atom. The proportion of protecting the carboxyl groups in the formula (I) with R₃ and R₄ as an organic protecting group is 20% or more, and preferably 70% or more.

On the other hand, in the polyimide having the structural unit represented by the formula (II) described above, R₁ is the same as defined in the formula (I), and R₅ is an aromatic or aliphatic hydrocarbon residue having a valence of (2+n). Specific examples of R₅ include the following groups, but R₅ is not limited to these.

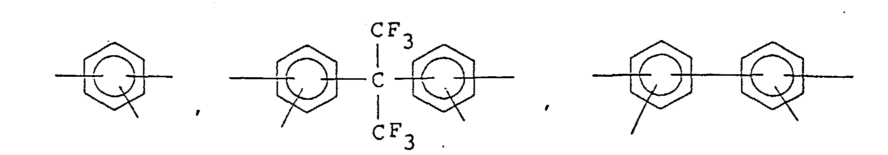

In all the structural units represented by the formula (II), it is not necessary for R₅ to be the same.

R₅ has at least one hydroxyl group protected by an organic protecting group (R₆) which can be eliminated under acidic or basic conditions. Examples of the organic protecting group of R₆ include the same groups as in the formula (I). Of those groups, tetrahydropyranyl group and t-butyl group are preferred.

In the structural unit represented by the formula (III), examples of R₁ and R₂ include the same residues as in the formula (I).

In the structural unit represented by the formula (IV), examples of R₁ and R₆ include the same residues as in. the formula (II).

In the above formulae (I) to (IV), all the groups of each of R₁ to R₆ need not be the same and may differ from each other.

The polyimide precursor having a structural unit represented by the formula (I) can be obtained by, for example, the following method.

An aromatic or aliphatic tetracarboxylic dianhydride containing R₁ in the molecule thereof and an aromatic or aliphatic diamine containing R₂ in the molecule thereof are reacted in almost equimolar amounts in an organic solvent such as N-methyl-2-pyrrolidone, dimethylacetamide, dimethylformamide, dimethyl sulfoxide, methylphosphoramide, or the like.

To the polyimide precursor obtained by the above reaction, a carboxyl-protecting agent having R₃ and R₄ and, if required and necessary, a reaction catalyst are added. The protecting agent is then reacted with the polyimide precursor at a temperature between room temperature and about 80°C to obtain a polyimide precursor having the desired structural unit.

The polyimide having a structural unit represented by the formula (II) can be obtained by, for example, the following method.

An aromatic or aliphatic tetracarboxylic dianhydride having R₁ in the molecule thereof and an aromatic or aliphatic diamine having in the molecule thereof R₅ containing at least one hydroxyl group are reacted in almost equimolar amounts in the same organic solvent as used in the above-described polyimide precursor preparation, thereby obtaining a polyimide precursor having a hydroxyl group. This polyimide precursor is then converted to an imide by a chemical imide-forming method or a heat-solution imide-forming method, thereby obtaining a polymer comprising imide structural units or a polymer comprising imide precursor structural units and imide structural units. The polymer thus obtained shows high solubility in organic solvents. It is preferred that this polymer is dissolved in an aqueous alkali solution, an alcohol, or a mixture thereof. Subsequently, the hydroxyl groups present in the molecule of this polymer are protected by a protecting agent having an organic protecting group of R₆ to obtain a polyimide having the desired structural unit.

The polyimide having a structural unit represented by the formula (III) can be easily obtained by a method in which a polyimide precursor is prepared using a diamine component having no hydroxyl group and this polyimide precursor is converted to an imide.

The first heat-resistant positive photoresist composition of the present invention which comprises the above-described polyimide precursor or polyimide containing an organic protecting group in the structural unit as shown in the formula (I) or (II) further contains a compound capable of inducing an elimination reaction of the organic protecting group upon irradiation with actinic ray such as ultraviolet ray or visible ray. Examples of such compound include diallylsulfonium salts, triallylsulfonium salts, dialkylphenacylsulfonium salts, allyldiazonium salts, aromatic tetracarboxylic acid esters, aromatic sulfonic acid esters, nitrobenzyl esters, aromatic sulfamides, and the like. Such compounds may be used in combination of two or more thereof or in combination with other sensitizer if required and necessary. This compound capable of inducing an elimination reaction of the organic protecting group is added to the photoresist composition in an amount of from 5 to 50 parts by weight, preferably from 10 to 20 parts by weight, per 100 parts by weight of the polyimide precursor or polyimide having a structural unit of the formula (I) or (II). If the amount of the compound added is too small, the elimination rate for the protecting group becomes so low that the sensitivity of the resulting photoresist composition deteriorates. If the amount thereof is too large, there are cases where the storage stability of the resulting photoresist solution and the image-forming properties thereof are adversely affected.

In the heat-resistant positive photoresist composition of the present invention, the photoresist composition comprising a polyimide precursor having a structural unit represented by formula (I) in which at least one of R₃ and R₄ is hydrogen atom further contains a compound which becomes basic upon irradiation with actinic ray such as ultraviolet ray or visible rays. Preferred examples of such compound include 2,6-dimethyl-3,5-dicarboxy-4-(2'-nitrophenyl)-1,4-dihydropyridine derivatives represented by the structural formula 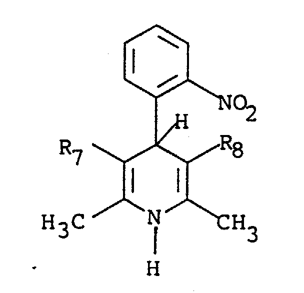 wherein R₇ and R₈ each is methylcarbonyl group, methoxycarbonyl group, ethoxycarbonyl group, propoxycarbonyl group, butoxycarbonyl group, anilinocarbonyl group, o-toluidinocarbonyl group, benzyloxycarbonyl group, cyano group, or the like, and preferably is methoxycarbonyl group.

The compounds represented by the above structural formula can be obtained by, for example, a condensation method proposed by Hinkel et al. (J. Chem. Soc., 1931, 1835, 1931). If required and necessary, the above compounds can be added to the polyimide precursor having a structural unit represented by the formula (I) as a mixture of two or more thereof or in combination with a conventional sensitizer. The addition amount of the compound which becomes basic upon irradiation with actinic ray is from 5 to 50 parts by weight, preferably from 10 to 25 parts by weight, per 100 parts by weight of the polyimide precursor. If the amount of the compound added is too small, photosensitive films obtained from the resulting photoresist composition tend to show poor solubility contrast (difference on dissolution rate to an alkali between exposed portion and unexposed portion). If the amount thereof is too large, there are cases that the storage stability of the resulting photoresist solution and the image-forming properties thereof are adversely affected, and that the film thickness reduction becomes large when the patterned films are subjected to heat treatment after the pattern formation.

When a film obtained from the heat-resistant positive photoresist composition of the present invention is used as a photoresist, a good pattern can be obtained because the polyimide precursor or polyimide having organic protecting groups undergoes the elimination of the organic protecting groups therefrom upon irradiation with actinic ray to thereby show improved alkali solubility. In the case of the composition comprising an unprotected polyimide precursor and a compound which becomes basic upon irradiation with actinic ray, films obtained from this composition come to show improved alkali solubility, because the compound, when irradiated with actinic ray, undergoes intramolecular rearrangement to change its structure to a structure containing a pyridine skeleton and to become basic, and some interaction takes place between the resulting basic compound and the polyimide precursor.

One example of the process for forming an image using the heat-resistant positive photoresist composition of the present invention is described below.

First, either a polyimide precursor having a structural unit represented by the formula (I) in which the carboxyl group is protected or a polyimide having a structural unit represented by the formula (II) in which the hydroxyl group is protected is dissolved in the above-described organic solvent together with a compound capable of inducing an elimination reaction of the protecting groups present in the polyimide precursor or polyimide upon irradiation with actinic ray, thereby to prepare a photosensitive liquid. In the case where a polyimide precursor having a structural unit represented by formula (I) in which R₃ and R₄ each is hydrogen atom and no protecting group is present is used, this polyimide precursor is used in combination with a compound which becomes basic upon irradiation with actinic rays in place of the compound capable of inducing a protecting group-eliminating reaction, thereby to prepare a photosensitive liquid. The photosensitive liquid thus prepared is then coated on a suitable substrate at a dry thickness of from 1 to 30 µm, preferably from 3 to 10 µm.

The resulting coating film is dried and then exposed to light through an ordinary photomask. After the exposure, post-heating is conducted, for example, at a temperature of from 80 to 160°C, followed by developing treatment in which the irradiated areas are removed by means of a developing solution using an immersion or spraying method or other technique. In the case where the heat-resistant positive photoresist composition of the present invention which is used to form the photoresist contains a compound becoming basic upon irradiation with actinic rays, the heating step may be conducted prior to the exposure step. As the developing solution for use in the developing treatment, solutions capable of completely dissolving and removing the exposed areas of the film within a suitable period of time are preferably used. Examples of such developing solutions include aqueous alkaline solutions of inorganic bases such as sodium hydroxide, potassium hydroxide, and the like and aqueous alkaline solutions of organic bases such as propylamine, butylamine, monoethanolamine, tetramethylammonium hydroxide (hereinafter referred to as TMAH), choline, and the like. These bases may be used alone or in combination of two or more thereof. To this aqueous alkaline solution, an organic solvent such as an alcohol or a surfactant selected from various kinds can be added if required and necessary.

After development, the resulting film is washed with a rinsing liquid to obtain an image having the desired pattern.

The thus-obtained image-bearing film is subjected to a final high-temperature heat treatment (about 200 to 400°C), thereby to give an image-bearing polyimide resist having heat resistance.

As described above, since the heat-resistant positive photoresist composition of the present invention employs a polyimide precursor or polyimide having a specific structure, irradiation of the composition with actinic ray such as ultraviolet ray yields a carboxyl or hydroxyl group in the structural unit and, as a result, the polymer component in the photoresist composition becomes alkali-soluble and the photoresist composition shows high sensitivity and high resolving power which have not been attained with conventional heat-resistant positive photoresist compositions. Thus, practically useful positive patterns can be formed.

Moreover, according to the present invention, since both the protecting agent for forming an organic protecting group and the compound becoming basic upon irradiation with actinic ray are ordinary organic compounds, inclusion of ionic impurities from these compounds into the photoresist composition hardly occurs and, hence, the number of steps necessary for the production of a heat-resistant positive photoresist and the cost for the production thereof can be reduced, which has not been attained by conventional processes.

A further advantage of the present invention is that since the polyimide resist finally obtained through high-temperature heat treatment has excellent heat resistance, electrical properties, and mechanical properties, it can be advantageously used in the semiconductor industry as a protective film for solid elements or circuit substrates or as a material for forming insulating films.

The present invention will be explained below in more detail by reference to the following examples, but the invention is not construed as limiting thereto.

### EXAMPLE 1

Tetracarboxylic dianhydrides respectively having the hydrocarbon residues R₁ shown in Table 1 and diamines respectively having the hydrocarbon residues R₂ shown in Table 1 were reacted in almost equimolar amounts at room temperature in N-methyl-2-pyrrolidone (hereinafter referred to as "NMP"), thereby obtaining polyimide precursor solutions 1 to 5 in which the polyimide precursors had a structural unit represented by the formula (I) described hereinabove.

To each of the above-obtained polyimide precursor solutions was added 3,4-dihydro-α-pyran in an amount of 1/2 by weight of the weight of the NMP and then added p-toluenesulfonic acid as an acidic catalyst in an amount of 1/2 by mole of the mole of the tetracarboxylic dianhydride. Each of the resulting mixtures was stirred overnight at room temperature. The solid components were reprecipitated in methanol (-10°C), and the precipitates were separated and then dried overnight with a vacuum dryer(13,3 Pa (0.1 Torr), 35°C).

The dried solid products were redissolved in NMP. To each of these solutions was added p-nitrobenzyl-9,10-dimethoxyanthracene-2-sulfonate (hereinafter referred to as "NBAS"), which is a photo-decomposable proton generator,in an amount shown in Table 2.

Each of the resulting solutions was spin-coated on a silicon wafer and dried to form a film having a thickness of from 3 to 5 µm. The film was then exposed through a glass mask to light emitted by a 250W super-high-pressure mercury lamp placed at a distance of 30 cm from the film, for 3 minutes by means of vacuum contact exposure.

After the exposure, each resulting film was heated at 110°C for 10 minutes, developed with the developing solution shown in Table 2, and then rinsed with water. The resolution of each of the thus-prepared patterned films and the ratio of the remaining film thickness to the initial film thickness after high temperature heating (320°C/1 hr) are shown in Table 2.

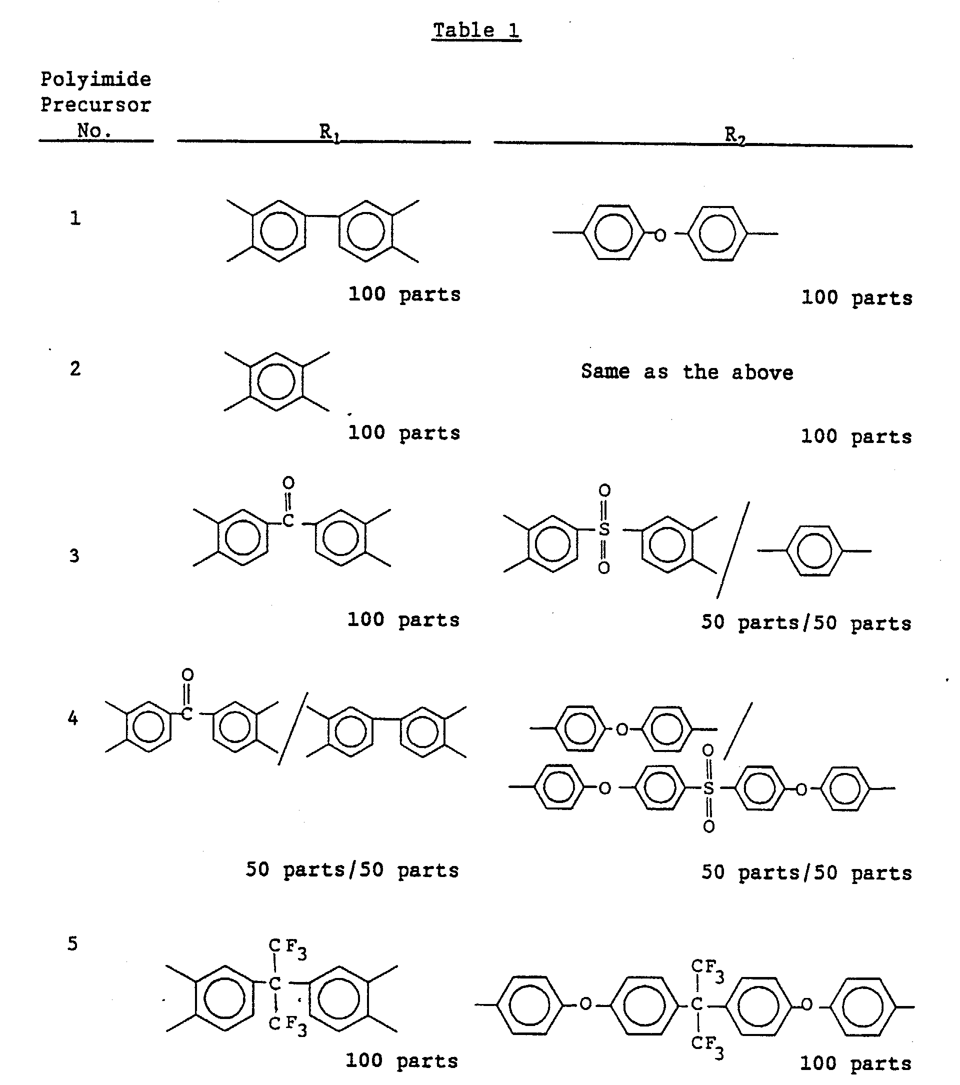

**Table 2**

| Precursor No. in Table 1*¹ | NBAS*² (wt%) | Developing solution*³ TMAH/MeOH | Resolution (aspect ratio) | Ratio of remaining film thickness to initial film thickness (%) |
|---|---|---|---|---|
| 1 | 20 | 8/2 | 0.8 | 65 |
| 2 | 20 | 8/2 | 0.8 | 60 |
| 3 | 20 | 6/4 | 0.9 | 70 |
| 4 | 15 | 6/4 | 0.9 | 70 |
| 5 | 15 | 8/2 | 1.7 | 70 |

| | | | | |
|---|---|---|---|---|
| *1 Concentration = 15 wt%/NMP | | | | |
| *2 Based on the solid polyimide precursor amount | | | | |
| *3 Concentration = 2 wt% (Nos. 1 & 2), 1 wt% (Nos. 3-5) | | | | |

### EXAMPLE 2

Using polyimide precursor 5 shown in Table 1, a photosensitive liquid was prepared in the same manner as in Example 1 except that the pyranyl group-introducing reaction was conducted using hydrochloric acid in place of the acid catalyst and that after the reaction, the excess 3,4-dihydro-α-pyran and hydrochloric acid were removed by vacuum distillation and NBAS was added directly to the resulting solution.

This photosensitive liquid was spin-coated and the resulting film was light-exposed and then developed, in the same manner as in Example 1. As a result, the same results as obtained in Example 1 were obtained.

### COMPARATIVE EXAMPLE 1

Using polyimide precursor 5 shown in Table 1, a photosensitive liquid was prepared in the same manner as in Example 1 except that the amount of NBAS added was changed to 2.5% by weight. Spin-coating, exposure, and development were then conducted in the same manner as in Example 1.

As a result, the film after development had poor contrast and a relief image could not be obtained.

### COMPARATIVE EXAMPLE 2

Using polyimide precursor 5 shown in Table 1, a photosensitive liquid was prepared in the same manner as in Example 1 except that the amount of NBAS added was changed to 60% by weight. This photosensitive liquid, however, gave a film which was not uniform and showed considerable film thickness reduction in high-temperature heat treatment for imide formation. Thus, a good relief image could not be reproduced.

### EXAMPLE 3

Tetracarboxylic dianhydrides respectively having the hydrocarbon residues R₁ shown in Table 3 and diamines respectively having the hydrocarbon residues R₂ shown in Table 3 were reacted in almost equimolar amounts at room temperature for 24 hours in dimethylacetamide, thereby obtaining polyimide precursor solutions 6 to 10 having a structural unit represented by the above-described formula (I) wherein R₃ and R₄ each was hydrogen atom.

On the other hand, 2-nitrobenzaldehyde was mixed with methyl acetoacetate (or ethyl acetoacetate) in an amount of 2.2 times the mole of the 2-nitrobenzaldehyde. Methyl alcohol having a temperature of -10°C was added thereto in an amount of 5 - 6 times the weight of 2-nitrobenzaldehyde, and the resulting mixture was stirred for several minutes. 25 wt% Aqueous ammonia solution was added to the solution with stirring in an amount such that the amount of ammonia became 1.5 times the mole of 2-nitrobenzaldehyde. This mixture was refluxed with heating for 5 hours, and the resulting reaction product was separated and purified by recrystallization or column chromatography. Thus, 2,6-dimethyl-3,5-dicarboxymethyl-4-(2'-nitrophenyl)-1,4-dihydropyridine (P-Me) or 2,6-dimethyl-3,5-dicarboxyethyl-4-(2'-nitrophenyl)-1,4-dihydropyridine (P-Et) was obtained.

Either of the thus-prepared two compounds was added to each of the above-obtained polyimide precursors in an amount shown in Table 4.

Each of the resulting solutions was spin-coated on a silicon wafer and dried at 80°C to form a film having a thickness of from 3 to 5 µm. The film was then exposed through a glass mask to light emitted by a 250W super-high-pressure mercury lamp placed at a distance of 30 cm from the film, for 3 minutes by means of vacuum contact exposure.

After the exposure, each resulting film was heated at 150°C for 10 minutes, developed for 3 minutes with a 1.5 wt% aqueous solution of tetramethylammonium hydroxide, and then rinsed with water. The resolution of each of the thus-prepared patterned films and the ratio of remaining film thickness thereof to initial film thickness after high-temperature heating (350°C/1 hr) are shown in Table 4. These five patterned films according to the present invention all showed values on or above practical levels.

### EXAMPLE 4

Using polyimide precursor solution 7 shown in Table 3, image formation was conducted in the same manner as in Example 3 except that the heating step was conducted prior to the exposure step.

As a result, a patterned film could be obtained which had good properties almost equal to those of the film obtained by using polyimide precursor 7 and light-exposing and then heating the same.

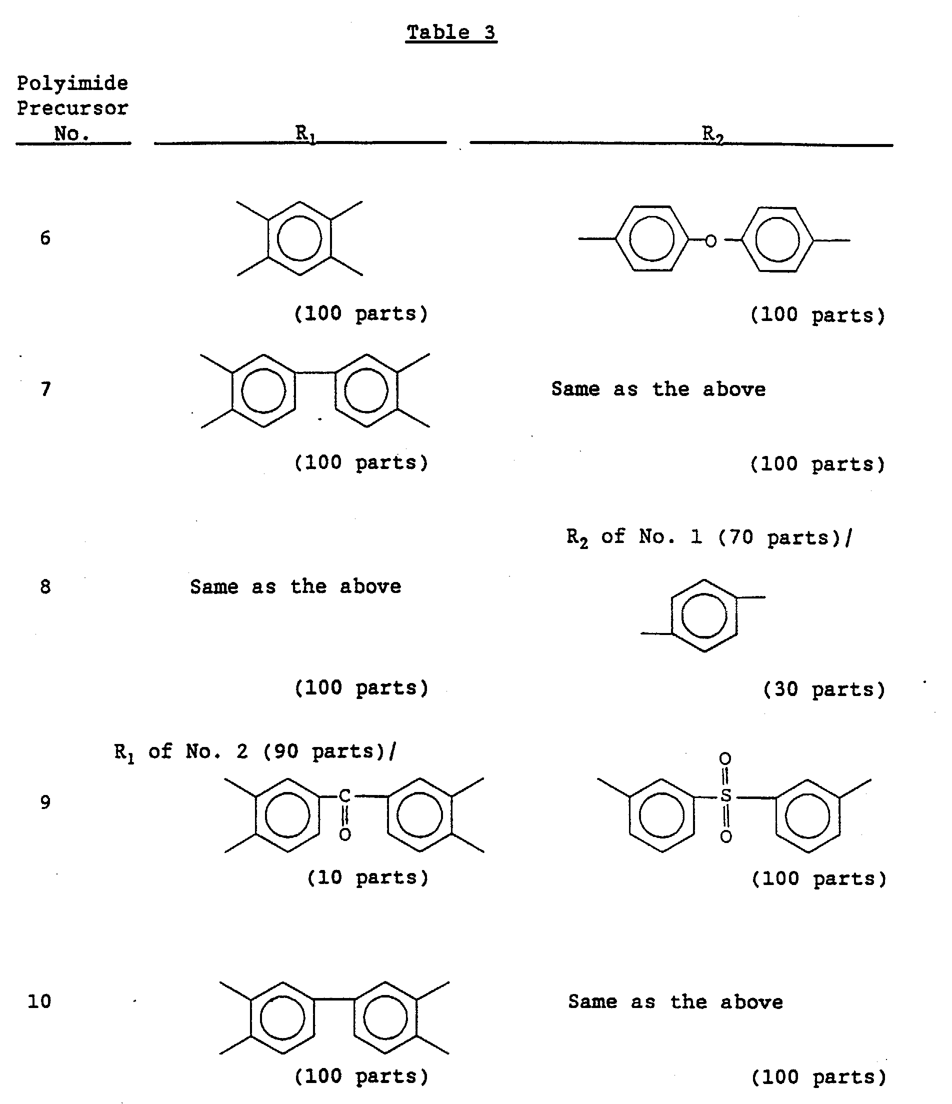

**Table 4**

| Precursor No. in Table 3 | Kind of compound (by weight per 100 parts by weight of solid resin) | Resolution (aspect ratio) | Ratio of remaining film thickness to initial film thickness (%) |
|---|---|---|---|
| 6 | P-Me*¹ (15 parts) | 1.0 | 70 |
| 7 | P-Me (20 parts) | 0.8 | 73 |
| 8 | P-Me (25 parts) | 0.8 | 68 |
| 9 | P-Et*² (15 parts) | 0.9 | 75 |
| 10 | P-Et (20 parts) | 1.1 | 75 |

| | | | |
|---|---|---|---|
| *¹ P-Me: 2,6-Dimethyl-3,5-dicarboxymethyl-4-(2'-nitrophenyl)-1,4-dihydropyridine | | | |
| *² P-Et: 2,6-Dimethyl-3,5-dicarboxyethyl-4-(2'-nitrophenyl)-1,4-dihydropyridine | | | |

### COMPARATIVE EXAMPLE 3

A polyimide precursor having a structural unit represented by formula (I) wherein R₁ is 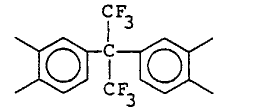 and R₂ is 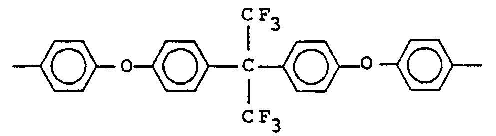 was subjected to ring closure by a conventional chemical imide-forming method (acetic anhydride, pyridine method), thereby synthesizing a soluble polyimide shown by the following formula.

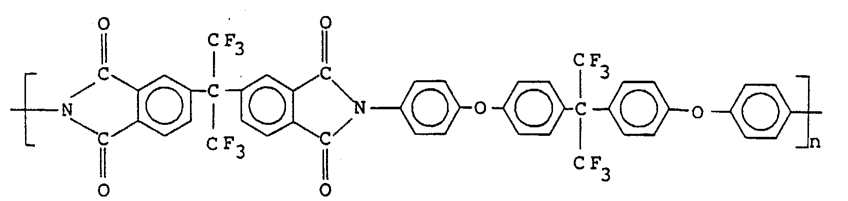

To 100 parts by weight of this polyimide was added 20 parts by weight of P-Me. Image formation was attempted using the resulting mixture in the same manner as in Example 3, but the final film had no contrast at all.

### COMPARATIVE EXAMPLE 4

To 100 parts by weight of polyimide precursor 7 shown in Table 3 was added 20 parts by weight of the compound of the formula 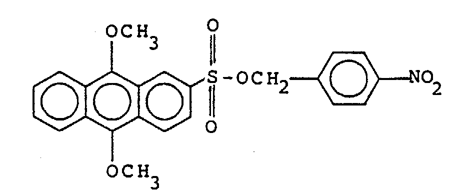 which is a compound becoming acidic upon light irradiation.

Using the resulting mixture, image formation was attempted in the same manner as in Example 3. However, despite of irradiation with light, the compound of the above formula did not cause a rearrangement reaction, and image formation was difficult.

### COMPARATIVE EXAMPLE 5

To 100 parts by weight of polyimide precursor 7 shown in Table 3 was added 20 parts by weight of the compound of the formula 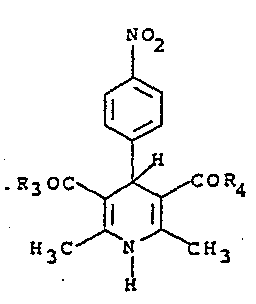 which is an isomer of P-Me. Using the resulting mixture, image formation was attempted in the same manner as in Example 3. However, despite of irradiation with light, the compound of the above formula did not cause a rearrangement reaction, and image formation was difficult.

### EXAMPLES 5 TO 9

Tetracarboxylic dianhydrides and diamines having structural units represented by formulae (II) to (IV) wherein R₁, R₅, and R₂ are groups as shown in Table 5 were reacted in almost equimolar amounts at room temperature in N-methyl-2-pyrrolidone to obtain poly(amic acid) solutions. To each of the solutions was then added m-xylene in a molar amount five times the theoretical molar amount of condensation water to be formed. The resulting mixtures were subjected to ring closure imide-forming reaction with heating at 150°C for 2 hours in a nitrogen stream, while removing the condensation water by a Deane-Stark trap. Thereafter, the resulting mixtures were heated to 170°C, and the m-xylene was removed over 30 minutes.

The resulting reaction mixtures were poured into water, and the solid products were sufficiently washed with water and then dried at 80°C under a reduced pressure of 13,3 Pa (0.1 Torr). Each of these dried products was dissolved in diglyme at a solid concentration of 30% by weight, and dimethylacetamide was further added thereto in an amount of 1/20 part by weight per part by weight of the diglyme.

To each of the thus-obtained solutions, 1/2 part by weight, per part by weight of the diglyme, of 3,4-dihydro-α-pyran was added, followed by addition of p-toluenesulfonic acid in an amount of 1/2 mole per mole of the tetracarboxylic dianhydride component unit. The resulting mixtures were stirred overnight at room temperature, and the reaction products formed were reprecipitated with methanol at -10°C. The solid products were then dried overnight at 35°C in a vacuum dryer at a reduced pressure of 13,3 Pa (0.1 Torr).

The dried solid products were redissolved in diglyme. To each of these solutions was added NBAS which is a photo-decomposable proton generator, in an amount shown in Table 6.

Each of the resulting solutions was spin-coated on a silicon wafer and dried to form a film having a thickness of from 3 to 5 µm. The film was then exposed through a glass mask to light emitted by a 250W super-high-pressure mercury lamp placed at a distance of 30 cm from the film, for 2 minutes by vacuum contact exposure. After the exposure, each resulting film was heated at 110°C for 10 minutes, developed with the developing solution shown in Table 6, and then rinsed with water. The resolution of each of the thus-prepared patterned films and the percentage of residual film thickness thereof after high-temperature heating at 320°C for 1 hour are shown in Table 6.

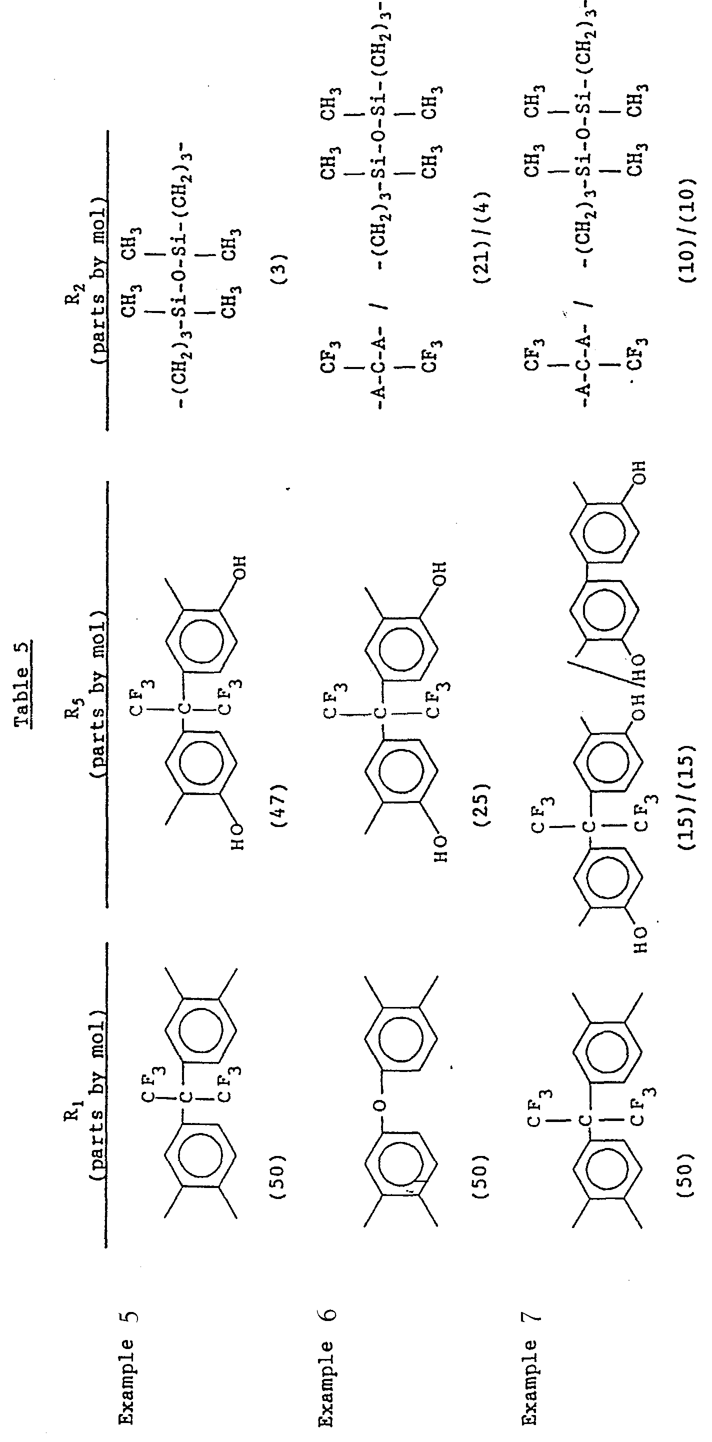

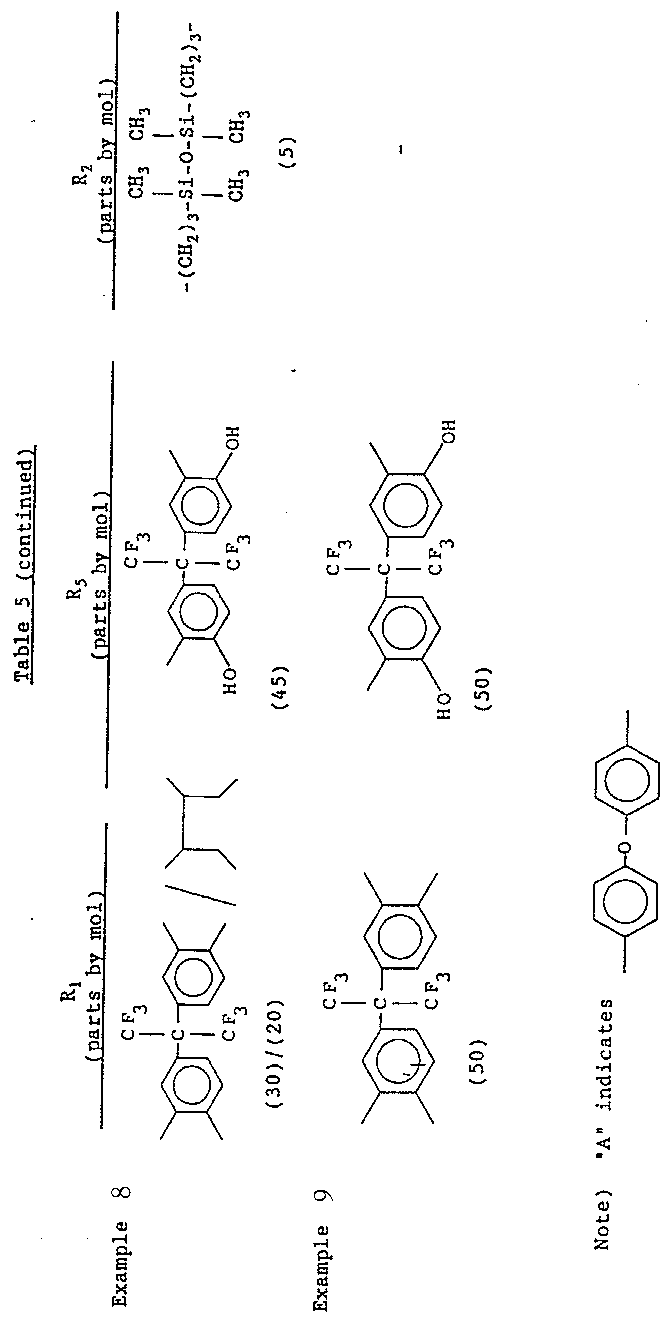

**Table 6**

| | NBAS¹⁾ (wt%) | Developing solution²⁾ TMAH/CH₃OH (volume ratio) | Resolution (aspect ratio) | Ratio of remaining film thickness to initial film thickness (%) |
|---|---|---|---|---|
| EXAMPLE 5 | 30 | 8/2 | 0.8 | 70 |
| EXAMPLE 6 | 20 | 8/2 | 0.8 | 85 |
| EXAMPLE 7 | 30 | 8/2 | 0.9 | 83 |
| EXAMPLE 8 | 30 | 8/2 | 0.9 | 76 |
| EXAMPLE 9 | 30 | 8/2 | 1.7 | 72 |

| | | | | |
|---|---|---|---|---|
| Note) 1) wt% based on the amount of solid polymer. | | | | |
| 2) TMAH being in the form of 1 wt% aqueous solutions | | | | |

### COMPARATIVE EXAMPLE 6

The polymer obtained in Example 5 and that obtained in Example 9 were redissolved in diglyme at a solid concentration of 30% by weight, respectively. Each solution was spin-coated on a silicon wafer and dried to form a film having a thickness of from 3 to 5 µm. The films thus obtained were heat-treated at 200°C and then subjected to a crosscut peeling test. As a result, the number of squares peeled off was zero in the film obtained from the polymer of Example 5, whereas in the case of the film obtained from the polymer of Example 9, 74 squares in the 100 squares were peeled off. Further, the same films were formed on a glass plate, peeled therefrom, and then examined for mechanical, electrical, and thermal properties. As a result, there was no difference between both films.

### COMPARATIVE EXAMPLE 7

Films of the polymer obtained in Example 5 and of the polymer obtained in Example 8 were obtained in the same manner as in Comparative Example 6, and were examined for transmittance and dielectric characteristics. As a result, the polymer of Example 8 which had been produced using an aliphatic tetracarboxylic acid showed a light transmittance curve shifted by about 10 nm to the shorter-wavelength side based on the transmittance curve for the polymer of Example 5. That is, the polymer of Example 8 had higher transparency than that of Example 5, and its dielectric constant at 1 MHz was lower by about 0.3 than that of the polymer of Example 5.

### EXAMPLE 10

Benzophenonetetracarboxylic dianhydride and 2,2-bis(3-amino-4-hydroxyphenyl)hexafluoropropane were reacted at room temperature in almost equimolar amounts in N-methyl-2-pyrrolidone, thereby obtaining a poly(amic acid) solution. To this solution was added m-xylene in a molar amount five times the theoretical molar amount of condensation water to be formed. The resulting mixture was subjected to ring closure imide-forming reaction with heating at 120°C for 1 hour in a nitrogen stream, while removing the condensation water by a Deane-Stark trap. Thereafter, nitrogen gas was introduced into the reaction system at an increased flow rate, and the m-xylene was removed from the system over 30 minutes. The resulting solution was poured into water, and the solid product obtained was sufficiently washed with water and then dried at 80°C overnight under a reduced pressure of 13,3 Pa (0.1 Torr).

Examination by proton NMR and TGA revealed that the percentage of ring closure of this polymer was about 87%. This polymer was dissolved in diglyme at a solid concentration of 30% by weight, and dimethylacetamide was then added thereto in an amount of 1/20 part by weight per part by weight of the diglyme. To this solution, 3,4-dihydro-α-pyran was added in an amount equal by weight to the amount of the diglyme, followed by addition of p-toluenesulfonic acid in a molar amount half the molar amount of the tetracarboxylic dianhydride component unit. The resulting mixture was stirred overnight at room temperature, and the reaction product formed was reprecipitated with methanol at -10°C. The solid product thus dbtained was dried overnight at 35°C in a vacuum dryer under a reduced pressure of13,3 Pa (0.1 Torr).

The dried solid product was redissolved in diglyme. To this solution was added NBAS which is a photo-decomposable proton generator, in an amount of 10% by weight based on the weight of the solid polymer. The resulting solution was spin-coated on a silicon wafer and dried to form a film having a thickness of from 3 to 5 µm. This film was then exposed through a glass mask to light emitted by a 250W super-high-pressure mercury lamp placed at a distance of 30 cm from the film, for 3 minutes by vacuum contact exposure. After the exposure, the resulting film was heated at 110°C for 10 minutes, developed at 23°C with a developing solution which was a 1:1 (by volume) mixture-of water and a 1 wt% aqueous solution of tetramethylammonium hydroxide, and then rinsed with water. As a result, a relief image having an aspect ratio of about 1.0 was obtained. The ratio of remaining film thickness to initial film thickness after high-temperature heating at 320°C for 1 hour was about 70%.

### COMPARATIVE EXAMPLE 8

Using the same monomers as used in Example 10, imide-forming reaction was conducted with heating at 150°C. However, the reaction mixture gelled 35 minutes after the initiation of the reaction.

### EXAMPLE 11

The polymer obtained in Example 5 which had undergone imide-forming reaction with heating was redissolved in diglyme at a solid concentration of 20% by weight. To the solution was added sulfuric acid in an amount of 0.5% by weight based on the weight of the diglyme. Isobutylene was blown into the above solution in a molar amount about 1.5 times the molar amount of the hydroxyl groups present in the polymer, and reaction was conducted overnight at room temperature. Using the resulting polymer, image formation was conducted in the same manner as in Example 5. As a result, an image having an aspect ratio of 0.8 was obtained.

While the invention has been described in detail and with reference to specific embodiments thereof, it will be apparent to one skilled in the art that various changes and modifications can be made therein without departing from the scope of the claims.

## Claims

1. A heat resistant positive photoresist composition, which comprises either a polyimide precursor having a structural unit represented by formula (I): 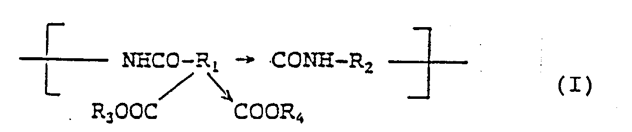 wherein
the -COOR₃ and -COOR₄ groups should always take the ortho-positions or adjacent positions with respect to the -CONH-linkages;
R₁ represents a tetravalent aromatic or aliphatic hydrocarbon residue or a diphenyl ether group, a diphenyl sulfone group, a benzophenone group or a diphenylhexafluoropropane group; R₂ represents a divalent aromatic or aliphatic hydrocarbon residue or a diphenyl ether group, a diphenyl thioether group, a benzophenone group, a diphenylhexafluoropropane group, a diphenylsulfoxide group, a diphenyl sulfone group or a pyridine group; and R₃ and R₄ each represents a hydrogen atom or an organic protecting group selected from tetrahydropyranyl, phthalimidomethyl, p-nitrobenzyl, p-methoxybenzyl, t-butyl, methoxymethyl, triphenylmethyl.
and tetrahydro-2-thiopyranyl which can be eliminated under acidic or basic conditions, thereby providing the corresponding carboxyl group;
or a polyimide having a structural unit represented by formula (II) : 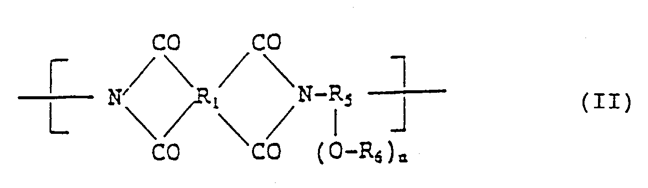 wherein R₁ is the same as defined above; R₆ represents an organic protecting group selected from tetrahydropyranyl, phthalimidomethyl, p-nitrobenzyl, p-methoxybenzyl, t-butyl, methoxymethyl, triphenylmethyl and tetrahydro-2-thiopyranyl which can be eliminated under acidic or basic conditions, thereby providing a hydroxyl group; R₅ represents an aromatic or aliphatic hydrocarbon residue having a valence of (2+n) and containing at least one hydroxyl group protected by the organic protecting group of R₆; and n is an integer of 1 to 5;
and further comprises a compound capable of inducing an elimination reaction of the organic protecting groups in the polyimide or polyimide precursor upon irradiation with actinic rays in an amount of 5 to 50 parts by weight per 100 parts by weight of the polyimide precursor or polyimide having a structural unit represented by formula (I) or (II);
and/or in case the composition comprises a polyimide precursor having a structural unit represented by formula (I), wherein at least one of R₃ and R₄ is a hydrogen atom, a compound which becomes basic upon irradiation with actinic rays is additionally present in the composition in an amount of 5 to 50 parts by weight per 100 parts by weight of the polyimide precursor.

2. The heat-resistant positive photoresist composition of claim 1, wherein R₁ is selected from the group consisting of benzene, naphthalene, perylene, diphenyl, diphenyl ether, diphenyl sulfone, diphenylpropane, diphenylhexafluoropropane, benzophenone, butane and cyclobutane.

3. The heat-resistant positive photoresist composition of claim 1, wherein R₂ is selected from the group consisting of diphenyl ether, diphenyl thioether, benzophenone, diphenylmethane, diphenylpropane, diphenylhexafluoropropane, diphenyl sulfoxide, diphenyl sulfone, biphenyl, pyridine and benzene.

4. The heat-resistant positive photoresist composition of claim 1, wherein R₅ is

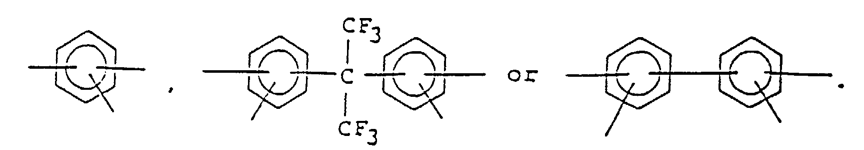

5. The heat resistant positive photoresist composition of claim 1, wherein said compound capable of inducing an elimination reaction of the organic protecting groups is at least one member selected from the group consisting of diallylsulfonium salts, triallylsulfonium salts, dialkylphenacylsulfonium salts, allyldiazonium salts, aromatic tetracarboxylic acid esters, aromatic sulfonic acid esters, nitrobenzyl esters and aromatic sulfamides.

6. The heat resistant positive photoresist composition of claim 1, wherein said compound which becomes basic upon irradiation with actinic rays is selected from 2,6-dimethyl-3,5-dicarboxy-4-(2'-nitrophenyl)-1,4-dihydropyridine derivatives represented by the structural formula 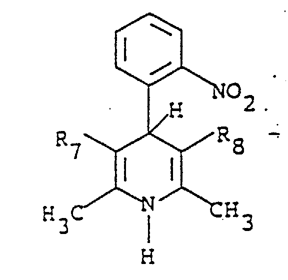 wherein R₇ and R₈ each represents a methylcarbonyl group, a methoxycarbonyl group, an ethoxycarbonyl group, a propoxycarbonyl group, a butoxycarbonyl group, an anilinocarbonyl group, an o-toluidinocarbonyl group, a benzyloxycarbonyl group or a cyano group.

7. A heat-resistant positive photoresist composition comprising a polyimide having a structural unit represented by formula (II) : 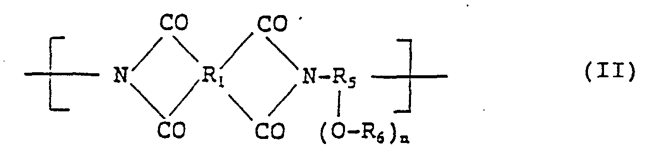 wherein
R₁ represents a tetravalent aromatic or aliphatic hydrocarbon residue or a diphenyl ether group, a diphenyl sulfone group, a benzophenone group or a diphenylhexafluoropropane group; R₆ represents an organic protecting group selected from tetrahydropyranyl, phthalimidomethyl, p-nitrobenzyl, p-methoxybenzyl, t-butyl, methoxymethyl, triphenylmethyl and tetrahydro-2-thiopyranyl which can be eliminated under acidic or basic conditions, thereby providing a hydroxyl group;
R₅ represents an aromatic or aliphatic hydrocarbon residue having a valence of (2+n) and containing at least one hydroxyl group protected by the organic protecting group of R₆; and n is an integer of 1 to 5;
and further having a structural unit represented by formula (III): 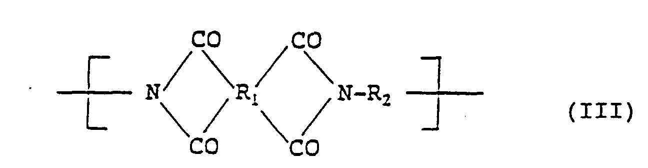 wherein R₁ is the same as the defined above and R₂ represents a divalent aromatic or aliphatic hydrocarbon residue or a diphenyl ether group, a diphenylthioether group, a benzophenone group, a diphenylhexafluoropropane group, a diphenyl sulfoxide group, a diphenyl sulfone group or a pyridine group;
and/or a structural unit represented by formula (IV): 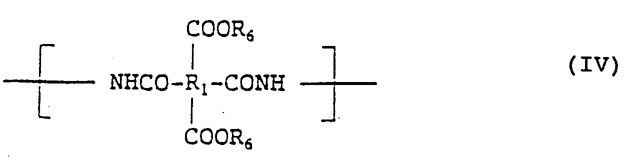 wherein R₁ and R₆ are the same as defined above;
said heat-resistant positive photoresist composition further comprising a compound capable of inducing an elimination reaction of the organic protecting groups in the polyimide upon irradiation with actinic rays .

8. A heat-resistant positive photoresist composition comprising a polyimide having a structural unit represented by formula (II) : 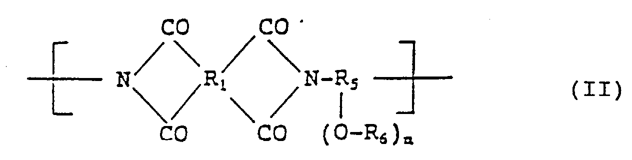 and further having a structural unit represented by formula (III): 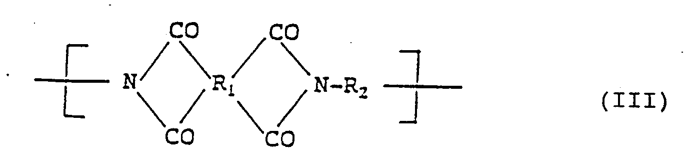 and/or a structural unit represented by formula (IV): 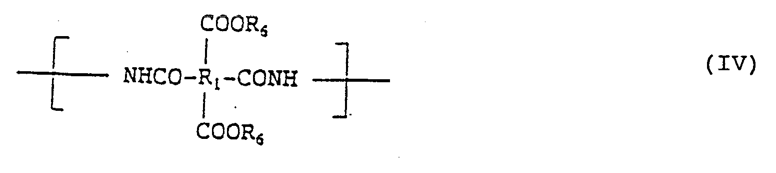 wherein R₆ is tetrahydropyranyl and R₁, R₅ and R₂ are units represented by the formulae 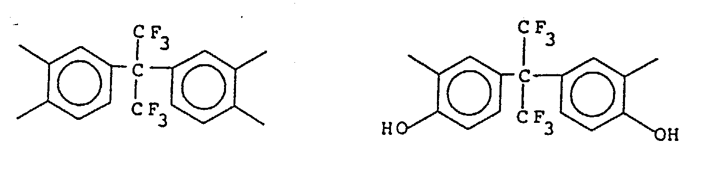 and 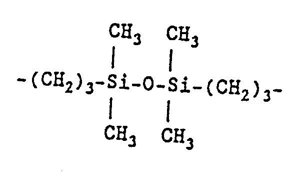 respectively, or wherein R₆ is tetrahydropyranyl and R₁, R₅ and R₂ are units represented by the formulae 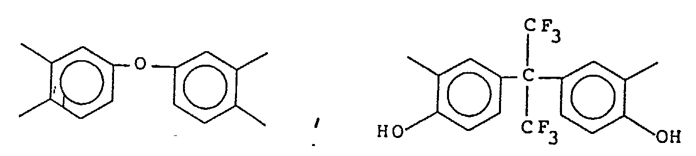 and 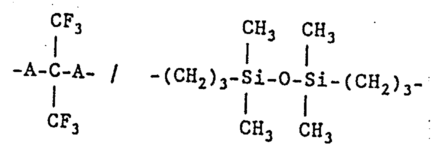 respectively, wherein "A" indicates 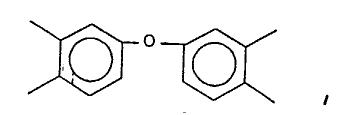 or wherein R₆ is tetrahydropyranyl and R₁, R₅ and R₂ are units represented by the formulae 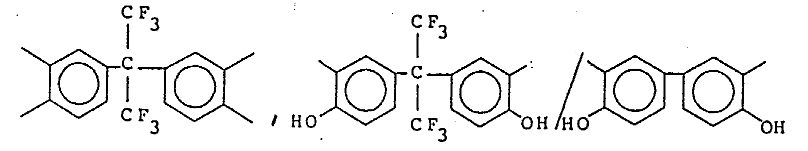 and 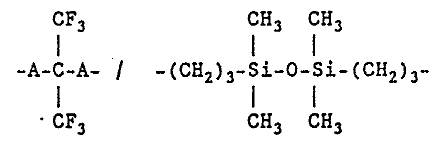 respectively, wherein "A" is the same as defined above, or
wherein R₆ is tetrahydropyranyl and R₁, R₅ and R₂ are units represented bv the formulae 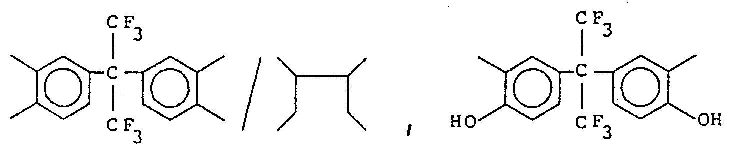 and 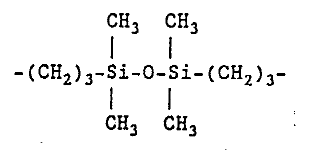 respectively, said heat-resistant positive photoresist composition further comprising a compound capable of inducing an elimination reaction of the organic protecting groups in the polyimide upon irradiation with actinic rays.

9. A photosensitive substrate obtained by coating a surface of a support with the heat resistant positive photoresist composition of any of claims 1 to 8.

10. A process for preparing a heat-resistant positive pattern, which comprises irradiating a film obtained from the heat-resistant positive photoresist composition of any of claims 1 to 8 with actinic rays through a photomask, followed by heat treatment, and then removing the irradiated areas of the resulting film by development with an alkaline developing solution, provided that the heat resistant positive photoresist composition comprises a polyimide precursor having a structural unit represented by formula (I).

11. A process for preparing a heat-resistant positive pattern, which comprises irradiating a film obtained from the heat-resistant positive photoresist composition of any of claims 1 to 8 with actinic rays through a photomask and then removing the irradiated areas of the resulting film by development with an alkaline developing solution, provided that the heat-resistant positive photoresist composition comprises a polyimide having a structural unit represented by formula (II).

## Patentansprüche

1. Wärmebeständige positive Photoresist-Zusammensetzung, welche entweder eine Polyimid-Vorstufe der strukturellen Einheit der Formel (I) : 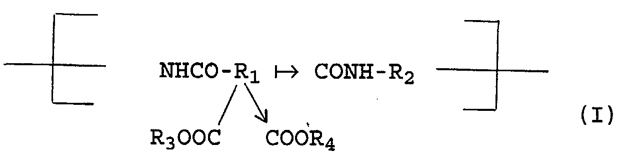 worin
die -COOR₃ und -COOR₄-Gruppen immer die ortho-Positionen oder benachbarte Positionen zu den -CONH-Verbindungsgruppen einnehmen sollen;
R₁ einen tetravalenten aromatischen oder aliphatischen Kohlenwasserstoffrest oder eine Diphenylethergruppe, eine Diphenylsulfongruppe, eine Benzophenongruppe oder eine Diphenylhexaflourpropangruppe darstellt; R₂ eine divalente aromatische oder aliphatische Kohlenwasserstoffgruppe oder eine Diphenylethergruppe, eine Diphenylthioethergruppe, eine Benzophenongruppe, eine Diphenylhexaflourpropangruppe, eine Diphenylsulfoxidgruppe, eine Diphenylsulfongruppe oder eine Pyridingruppe darstellt; und R₃ und R₄ jeweils ein Wasserstoffatom oder eine organische Schutzgruppe, gewählt aus Tetrahydropyranyl, Phthalimidomethyl, p-Nitrobenzyl, p-Methoxybenzyl, t-Butyl, Methoxymethyl, Triphenylmethyl und Tetrahydro-2-thiopyranyl bedeutet, die unter sauren oder basischen Bedingungen abgespalten werden kann und so die korrespondierende Carboxylgruppe bildet;
oder ein Polyimid mit der Struktureinheit der Formel (II) : 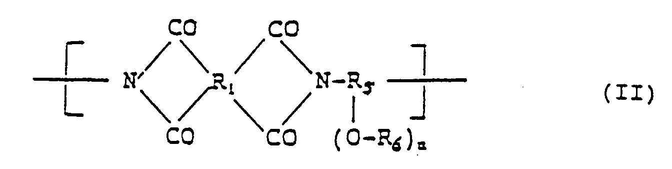 worin R₁ wie oben definiert ist; R₆ eine organische Schutzgruppe, gewählt aus Tetrahydropyranyl, Phthalimidomethyl, p-Nitrobenzyl, p-Methoxybenzyl, t-Butyl, Methoxymethyl, Triphenylmethyl und Tetrahydro-2-thiopyranyl bedeutet, welche unter sauren oder basischen Bedingungen abgespalten werden kann und so eine Hydroxylgruppe bildet; R₅ einen aromatischen oder aliphatischen Kohlenwasserstoffrest mit der Valenz (2+n) darstellt, welcher mindestens eine Hydroxylgruppe enthält die durch die organische Schutzgruppe R₆ geschützt ist; und n eine ganze Zahl von 1 bis 5 bedeutet;
enthält und weiter eine Verbindung, die eine Eliminierungsreaktion der organischen Schutzgruppen in dem Polyimid oder in der Polyimidvorstufe bei Bestrahlung mit aktinischen Strahlen induzieren kann, in einer Menge von 5 bis 50 Gewichtsteilen pro 100 Gewichtsteilen der Polyimidvorstufe oder des Polyimids mit der Struktureinheit der Formel (I) oder (II) enthält;
und/oder, wenn die Zusammensetzung eine Polyimidvorstufe mit einer Struktureinheit der Formel (I) enthält, worin mindestens eines von R₃ und R₄ ein Wasserstoffatom ist, eine Verbindung, die bei Bestrahlung mit aktinischen Strahlen basisch wird, zusätzlich in der Zusammensetzung in einer Menge von 5 bis 50 Gewichtsteilen pro 100 Gewichtsteilen der Polyimidvorstufe enthalten ist.

2. Wärmebeständige positive Photoresist-Zusammensetzung nach Anspruch 1, worin R₁ gewählt ist aus der Gruppe, bestehend aus Benzol, Naphthalin, Perylen, Diphenyl, Diphenylether, Diphenylsulfon, Diphenylpropan, Diphenylhexaflourpropan, Benzophenon, Butan und Cyclobutan.

3. Wärmebeständige positive Photoresist-Zusammensetzung nach Anspruch 1, worin R₂ gewählt ist aus der Gruppe, bestehend aus Diphenylether, Diphenyltioether, Benzophenon, Diphenylmethan, Diphenylpropan, Diphenylhexaflourpropan, Diphenylsulfoxid, Diphenylsulfon, Biphenyl, Pyridin und Benzol.

4. Wärmebeständige positive Photoresist-Zusammensetzung nach Anspruch 1, worin R₅ 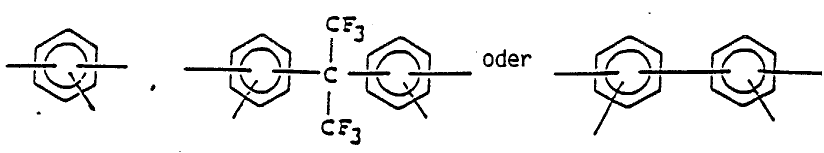 ist.

5. Wärmebeständige positive Photoresistzusammensetzung nach Anspruch 1, worin die Verbindung, die eine Eliminierungsreaktion der organischen Schutzgruppen induzieren kann, mindestens ein Glied ist aus der Gruppe, bestehend aus Diallylsulfonium-Salzen, Triallylsulfonium-Salzen, Dialkylphenacylsulfonium-Salzen, Allyldiazonium-Salzen, aromatischen Tetracarbonsäureestern, aromatischen Sulfonsäureestern, Nitrobenzylestern und aromatischen Sulfamiden.

6. Wärmebeständige positive Photoresist-Zusammensetzung nach Anspruch 1, worin die Verbindung, die bei Bestrahlung mit aktinischen Strahlen basisch wird, gewählt wird aus 2,6-Dimethyl-3,5-dicarboxy-4-(2'-nitrophenyl)-1,4-dihydropyridin-Derivaten der Formel 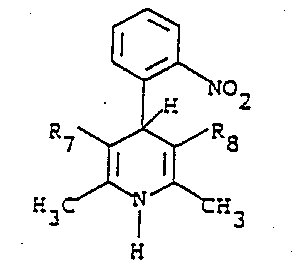 worin R₇ und R₈ jeweils eine Methylcarbonylgruppe, eine Methoxycarbonylgruppe, eine Ethoxycarbonylgruppe, eine Propoxycarbonylgruppe, eine Butoxycarbonylgruppe, eine Anilinocarbonylgruppe, eine o-Toluidinocarbonylgruppe, eine Benzyloxycarbonylgruppe oder eine Cyanogruppe bedeuten.

7. Wärmebeständige positive Photoresist-Zusammensetzung, umfassend ein Polyimid mit einer Struktureinheit der Formel (II) : 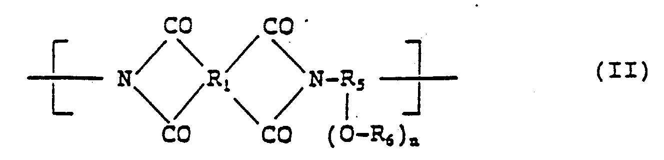 worin
R₁ einen tetravalenten aromatischen oder aliphatischen Kohlenwasserstoffrest oder eine Diphenylethergruppe, eine Diphenylsulfongruppe, eine Benzophenongruppe oder eine Diphenylhexafluorpropangruppe bedeutet; R₆ eine organische Schutzgruppe, gewählt aus Tetrahydropyranyl, Phthalimidomethyl, p-Nitrobenzyl, p-Methoxybenzyl, t-Butyl, Methoxymethyl, Triphenylmethyl und Tetrahydro-2-thiopyranyl bedeutet, die unter sauren oder basischen Bedingungen abgespalten werden kann und so eine Hydroxylgruppe bildet;
R₅ einen aromatischen oder aliphatischen Kohlenwasserstoffrest der Valenz (2+n) bedeutet welcher mindestens eine Hydroxylgruppe enthält, die durch die organische Schutzgruppe R₆ geschützt wird; und n eine ganze Zahl von 1 bis 5 bedeutet;
und außerdem eine Struktureinheit der Formel (III): 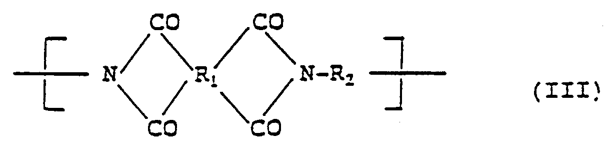 worin R₁ wie oben definiert ist und R₂ einen divalenten aromatischen oder aliphatischen Kohlenwasserstoffrest oder eine Diphenylethergruppe, eine Diphenylthioethergruppe, eine Benzophenongruppe, eine Diphenylhexaflourpropangruppe, eine Diphenylsulfoxidgruppe, eine Diphenylsulfongruppe oder eine Pyridingruppe bedeutet;
und/oder eine Struktureinheit der Formel (IV) : 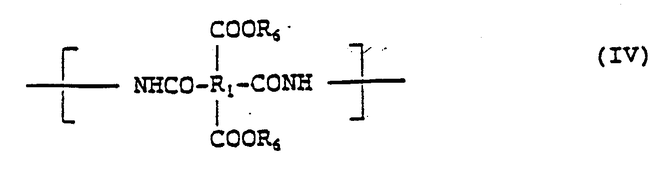 worin R₁ und R₆ wie oben definiert sind;
wobei die wärmebeständige positive Photoresist-Zusammensetzung außerdem eine Verbindung enthält, die eine Eliminierungsreaktion der organischen Schutzgruppen in dem Polyimid bei Bestrahlung mit aktinischen Strahlen induzieren kann.

8. Wärmebeständige positive Photoresist-Zusammensetzung, umfassend ein Polyimid mit einer Struktureinheit der Formel (II) : 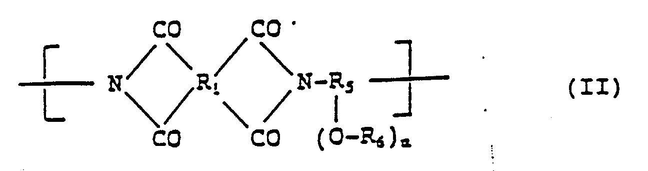 und außerdem eine Struktureinheit der Formel (III) : 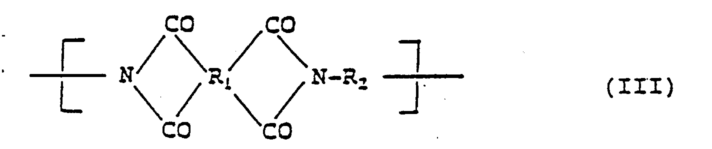 und/oder eine Struktureinheit der Formel (IV) : 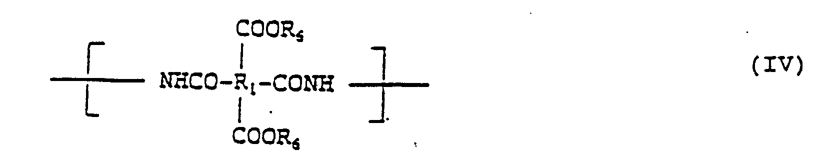 worin R₆ Tetrahydropyranyl und R₁, R₅, und R₂ Einheiten der Formeln 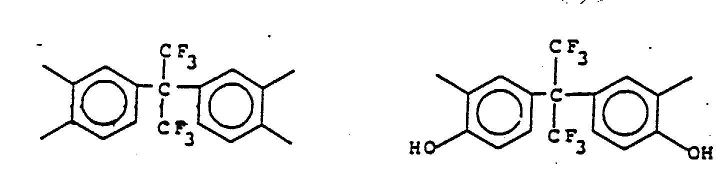 bzw. 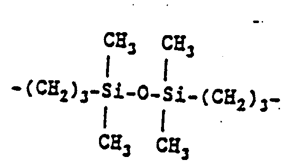 sind, oder
worin R₆ Tetrahydropyranyl und R₁, R₅ und R₂ Einheiten der Formeln 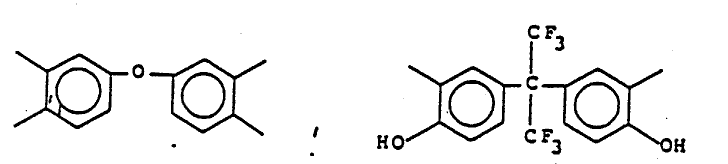 bzw. 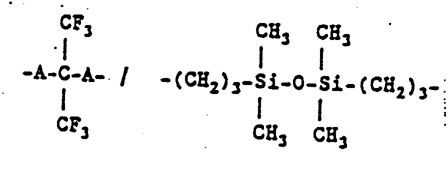 sind, worin "A" 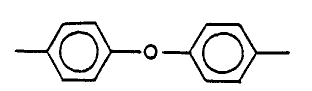 bedeutet, oder worin R₆ Tetrahydropyranyl und R₁, R₅ und R₂ Einheiten der Formeln 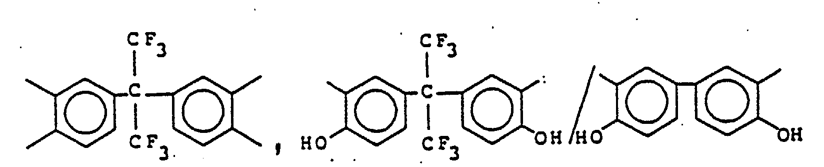 bzw. 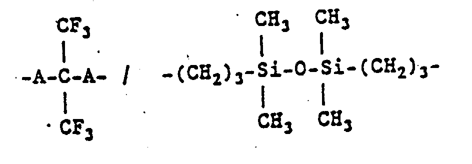 bedeuten, worin "A" wie oben befiniert ist, oder
worin R₆ Tetrahydropyranyl und R₁, R₅ und R₂ Einheiten der Formeln 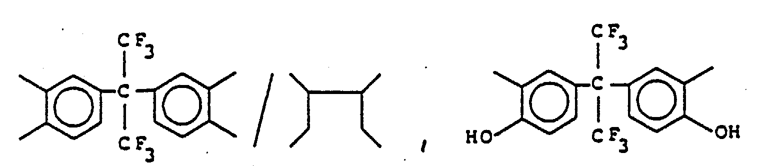 bzw. 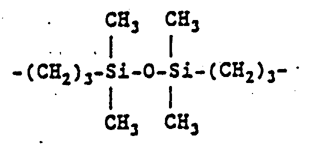 sind,
wobei die wärmebeständige positive Photoresist-Zusammensetzung außerdem eine Verbindung enthält, die eine Eliminierungsreaktion der organischen Schutzgruppen in dem Polyimid durch Bestrahlung mit aktinischen Strahlen induzieren kann.

9. Lichtempfindlicher Träger, erhältlich durch Beschichten einer Oberfläche eines Trägers mit der wärmestabilen positiven Photoresist-Zusammensetzung gemäß einem der Ansprüche 1 bis 8.

10. Verfahren zur Herstellung eines wärmebeständigen positiven Musters, umfassend Bestrahlen eines Films, der erhalten wurde aus der wärmebeständigen positiven Photoresist-Zusammensetzung gemäß einem der Ansprüche 1 bis 8, mit aktinischen Strahlen durch eine Photomaske, gefolgt von einer Wärmebehandlung und anschließend dem Entfernen der bestrahlen Bereiche des erhaltenen Films durch Entwicklung mit einer alkalischen Entwicklerlösung, unter der Voraussetzung, daß die wärmebeständige positive Photoresist-Zusammensetzung eine Polyimidvorstufe mit einer Struktureinheit der Formel (I) enthält.

11. Verfahren zur Herstellung eines wärmebeständigen positiven Musters, umfassend Bestrahlen eines Films, der erhalten wurde aus der wärmebeständigen positiven Photoresist-Zusammensetzung gemäß einem der Ansprüche 1 bis 8, mit aktinischen Strahlen durch eine Photomaske und anschließend Entfernen der bestrahlten Bereiche des resultierenden Films durch Entwicklung mit einer alkalischen Entwicklerlösung, unter der Voraussetzung daß die wärmebeständige positive Photoresist-Zusammensetzung ein Polyimid mit einer Struktureinheit der Formel (II) enthält.

## Revendications

1. Composition pour photorésist du type positif résistant à la chaleur, qui comprend soit un précurseur de polyimide ayant le motif structural représenté par la formule (I) : 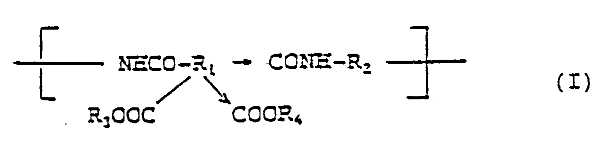 dans laquelle
les groupes -COOR₃ et -COOR₄ doivent toujours être en positions ortho ou adjacentes par rapport aux liaisons -CONH- ;
R₁ représente un reste hydrocarboné tétravalent aromatique ou aliphatique ou un groupe éther diphénylique, un groupe diphénylsulfone, un groupe benzophénone ou un groupe diphénylhexafluoropropane ; R₂ représente un reste hydrocarboné divalent aromatique ou aliphatique ou un groupe éther diphénylique, un groupe thioéther diphénylique, un groupe benzophénone, un groupe diphénylhexafluoropropane, un groupe diphénylsulfoxyde, un groupe diphénylsulfone ou un groupe pyridine ; et R₃ et R₄ représentent chacun un atome d'hydrogène ou un groupe organique protecteur choisi parmi le tétrahydropyrannyle, le phtalimidométhyle, le p-nitrobenzyle, le p-méthoxybenzyle, le t-benzyle, le méthoxyméthyle, le triphénylméthyle et le tétrahydro-2-thiopyrannyle qui peut être éliminé en milieux acides ou basiques, avec ainsi formation du groupe carboxyle correspondant ; soit un polyimide ayant le motif structural représenté par la formule (II): 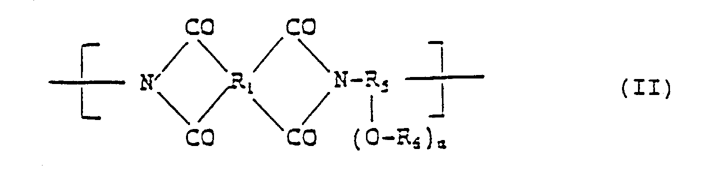 dans laquelle R₁ est tel que décrit ci-dessus ; R₆ représente un groupe organique protecteur choisi parmi le tétrahydropyrannyl, le phtalimidométhyl, le p-nitrobenzyle, le p-méthoxybenzyle, le t-butyle, le méthoxyméthyle, le triphénylméthyle et le tétrahydro-2-thiopyrannyle, qui peut être éliminé en milieux acides ou basiques, avec ainsi formation d'un groupe hydroxyle ; R₅ représente un reste hydrocarboné aromatique ou aliphatique ayant une valence de (2 + n) et contenant au moins un groupe hydroxyle protégé par le groupe organique protecteur de R₆ ; et n est un entier de 1 à 5 ;
et comprend en outre un composé, capable d'induire la réaction d'élimination des groupes organiques protecteurs dans le polyimide ou le précurseur de polyimide sous l'effet d'une irradiation par des rayons actiniques, en une quantité de 5 à 50 parties en masse pour 100 parties en masse du précurseur de polyimide ou du polyimide ayant le motif structural représenté par les formules (I) ou (II) ;
et/ou dans le cas où la composition contient un précurseur de polyimide ayant le motif structural représenté par la formule (I), dans laquelle au moins un des R₃ et R₄ est un atome d'hydrogène, un composé qui devient basique sous l'effet d'une irradiation par des rayons actiniques est présent en outre dans la composition en une quantité de 5 à 50 parties en masse pour 100 parties en masse de précurseur de polyimide.

2. Composition pour photorésist du type positif résistant à la chaleur selon la revendication 1, dans laquelle R₁ est choisi dans le groupe constitué par le benzène, le naphtalène, le pérylène, le diphényle, l'éther diphénylique, la diphénylsulfone, le diphénylpropane, le diphénylhexafluoropropane, la benzophénone, le butane et le cyclobutane.

3. Composition pour photorésist du type positif résistant à la chaleur selon la revendication 1, dans laquelle R₂ est choisi dans le groupe constitué par l'éther diphénylique, le thioéther diphénylique, la benzophénone, le diphénylméthane, le diphénylpropane, le diphénylhexafluoropropane, le diphénylsulfoxyde, la diphénylsulfone, le biphényle, la pyridine et le benzène.

4. Composition pour photorésist du type positif résistant à la chaleur selon la revendication 1, dans laquelle R₅ est

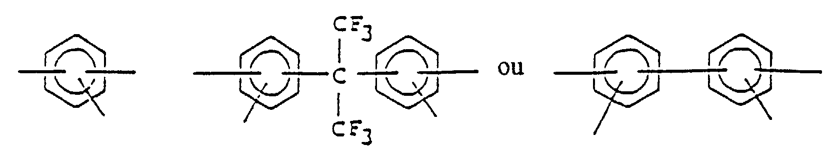

5. Composition pour photorésist du type positif résistant à la chaleur selon la revendication 1, dans laquelle ledit composé capable d'induire la réaction d'élimination des groupes organiques protecteurs est au moins un élément choisi dans le groupe constitué par les sels de diallylsulfonium, les sels de triallylsulfonium les sels de dialkylphénacylsulfonium, les sels d'allyldiazonium, les esters d'acides tétracarboxyliques aromatiques, les esters d'acides sulfoniques aromatiques, les esters de nitrobenzyle et les sulfamides aromatiques.

6. Composition pour photorésist du type positif résistant à la chaleur selon la revendication 1, dans laquelle ledit composé qui devient basique sous l'effet d'une irradiation par des rayons actiniques est choisi parmi les dérivés de la 2,6-diméthyl-3,5-dicarboxy-4-(2'-nitrophényl)-1,4-dihydropyridine représentés par la formule développée 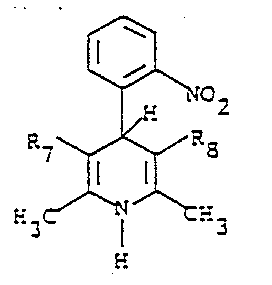 dans laquelle R₇ et R₈ représentent chacun un groupe méthylcarbonyle, un groupe méthoxycarbonyle, un groupe éthoxycarbonyle, un groupe propoxycarbonyle, un groupe butoxycarbonyle, un groupe anilinocarbonyle, un groupe o-toluidinocarbonyle, un groupe benzyloxycarbonyle ou un groupe cyano.

7. Composition pour photorésist du type positif résistant à la chaleur comprenant un polyimide ayant le motif structural représenté par la formule (II) : 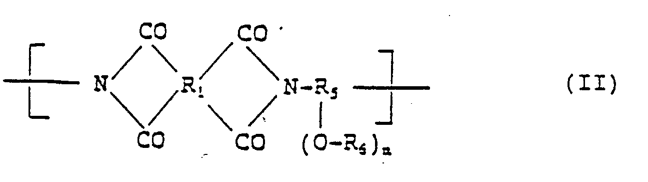 dans laquelle R₁
représente un reste hydrocarboné tétravalent aromatique ou aliphatique ou un groupe éther diphénylique, un groupe diphénylsulfone, un groupe benzophénone ou un groupe diphénylhexafluoropropane; R₆ représente un groupe organique protecteur choisi parmi le tétrahydropyrannyle, le phtalimidométhyle, le p-nitrobenzyle, le p-méthoxybenzyle, le t-butyle, le méthoxyméthyle, le triphénylméthyle et le tétrahydro-2-thiopyrannyle, qui peut être éliminé en milieux acides ou basiques, avec ainsi formation d'un groupe hydroxyle ;
R₅ représente un reste hydrocarboné aromatique ou aliphatique ayant une valence de (2 + n) et contenant au moins un groupe hydroxyle protégé par le groupe organique protecteur de R₆; et n est un entier de 1 à 5; et contenant en outre le motif structural représenté par la formule (III) : 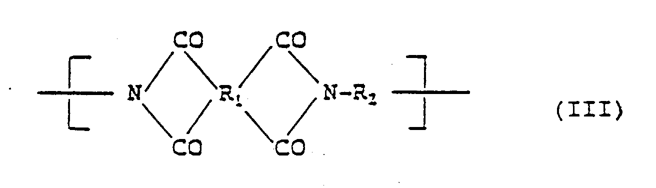 dans laquelle R₁ est tel que défini ci-dessus et R₂ représente un reste hydrocarboné divalent aromatique ou aliphatique ou un groupe éther diphénylique, un groupe thioéther diphénylique, un groupe benzophénone, un groupe diphénylhexafluoropropane, un groupe diphénylsulfoxyde, un groupe diphénylsulfone ou un groupe pyridine ;
et/ou le motif structural représenté par la formule (IV): 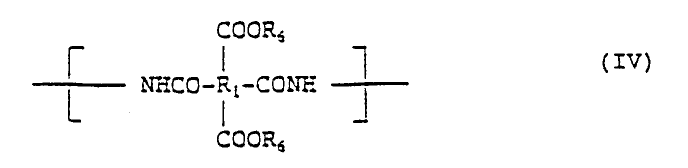 dans laquelle R₁ et R₆ sont tels que définis ci-dessus;
ladite composition pour photorésist du type positif résistant à la chaleur comprenant en outre un composé capable d'induire la réaction d'élimination des groupes organiques protecteurs dans le polyimide sous l'effet d'une irradiation par des rayons actiniques.

8. Composition pour photorésist du type positif résistant à la chaleur comprenant un polyimide ayant le motif structural représenté par la formule (II): 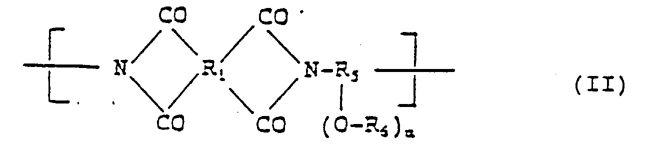 et contenant en outre le motif structural représenté par la formule (III) : 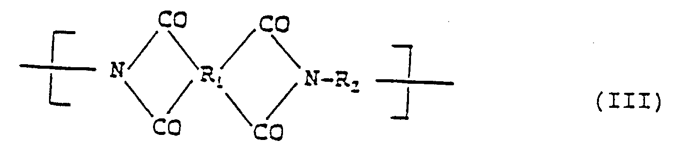 et/ou le motif structural représenté par la formule (IV) : 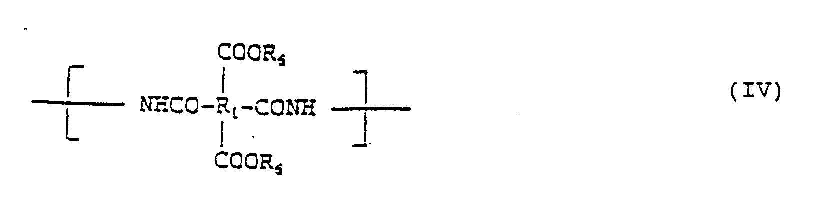 dans laquelle R₆ est le tétrahydropyrannyle et R₁, R₅ et R₂ sont des motifs représentés par les formules 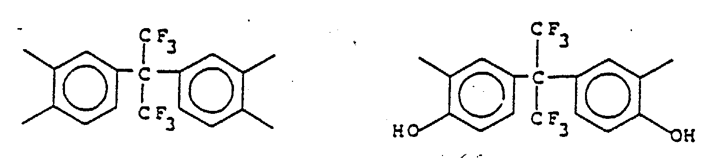 et 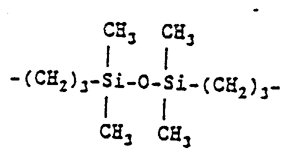 respectivement, ou
dans laquelle R₆ est le tétrahydropyrannyle et R₁, R₅ et R₂ sont des motifs représentés par les formules 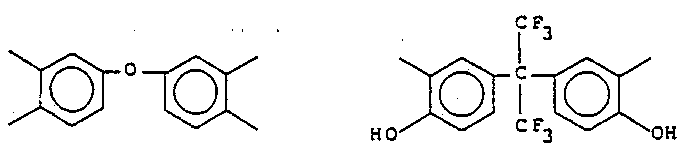 et 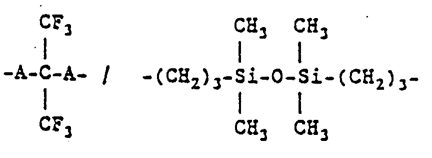 respectivement, "A" représentant 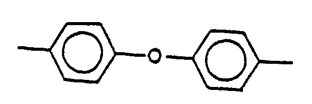 ou dans laquelle R₆ est le tétrahydropyrannyle et R₁, R₅ et R₂ sont des motifs représentés par les formules 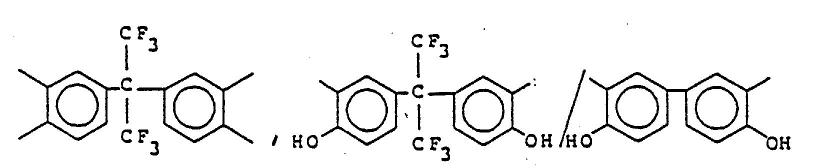 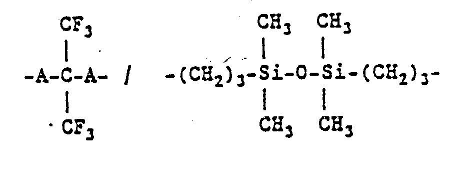 respectivement, "A" étant tel que défini ci-dessus, ou
dans laquelle R₆ est le tétrahydropyrannyle et R₁, R₅ et R₂ sont des motifs représentés par les formules 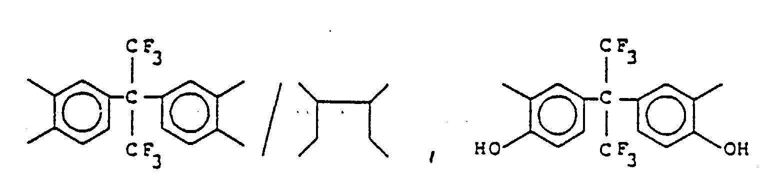 et 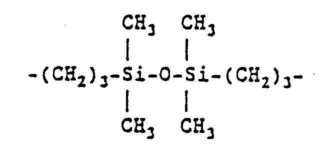 respectivement,
la dite composition pour photorésist du type positif résistant à la chaleur contenant en outre un composé capable d'induire la réaction d'élimination des groupes organiques protecteurs dans le polyimide sous l'effet d'une irradiation par des rayons actiniques.

9. Substrat photosensible obtenu en recouvrant la surface d'un support par la composition pour photorésist du type positif résistant à la chaleur selon une quelconque des revendications 1 à 8.

10. Procédé pour la préparation d'un motif du type positif résistant à la chaleur, comprenant l'irradiation d'un film obtenu à partir d'une composition pour photorésist du type positif résistant à la chaleur selon une quelconque des revendications 1 à 8 par des rayons actiniques au travers d'un photomasque, suivie d'un traitement thermique, et ensuite l'élimination des zones du film obtenu irradiées par développement par une solution de développement basique, sous réserve que la composition pour photorésist du type positif résistant à la chaleur contienne un précurseur de polyimide ayant un motif structural représenté par la formule (I).

11. Procédé pour la préparation d'un motif du type positif résistant à la chaleur, comprenant l'irradiation d'un film obtenu à partir d'une composition pour photorésist du type positif résistant à la chaleur selon une quelconque des revendications 1 à 8 par des rayons actiniques au travers d'un photomasque, et ensuite l'élimination des zones du film obtenu irradiées par développement par une solution de développement basique, sous réserve que la composition pour photorésist du type positif résistant à la chaleur contienne un précurseur de polyimide ayant un motif structural représenté par la formule (II).
